# EUROPEAN PATENT APPLICATION

(11) **EP 0 977 257 A2**
(43) Date of publication of application: **02.02.2000**
(21) Application number: 99202431.5
(22) Date of filing: 23.07.1999
(51) Int. Cl.: H01L 21/8242, H01L 27/108

(54) **Stacked capacitor DRAM cell and method of producing the same**

(30) Priority: 30.07.1998 US 94723 P
(71) Applicant: Texas Instruments Incorporated, Dallas, Texas 75251 (US)
(72) Inventor: Tsu, Robert Yung-Hsi, Plano, Texas (US); Ho, Chi-Chien, Plano, Texas (US)
(74) Representative: Holt, Michael

(57) **Abstract**

A plugged crown memory cell is disclosed. In one embodiment, a plugged crown memory cell includes a storage node plug (crown cell plug) and subsequent formed polysilicon cylinder or similar three dimensional structure.

In another embodiment, a method for manufacturing a plugged crown memory cell in accordance with the invention may include the following steps: (1) formation of storage node contact (memory cell plug); (2) formation of memory cell sidewall; and (3) etch back of crown poly and removal of core oxide (PSG) to form isolated and electrically separate memory cell.

## Description

### TECHNICAL FIELD OF THE INVENTION

This invention relates generally to the field of semiconductor memory cells, and more particularly to a plugged crown memory cell and its method of manufacture.

### BACKGROUND OF THE INVENTION

Dynamic random access memories (DRAMs) have a plurality of memory cells, each of which typically includes a storage capacitor and a transistor serving as a transfer gate for storing or eliminating charges. The plurality of memory cells are arranged on a substrate in a matrix arrangement and operate to permit a single cell in the memory to be selected by means of two-dimensional addressing within a given time period. A bit line (data line) voltage is supplied to the storage capacitor via a transistor so as to write information on each memory cell. Also, in order to read out the written information, the storage capacitor is connected to the data line via a gate and the voltage of the storage capacitor is thus monitored.

As DRAM devices become more dense, there is a constant push to decrease the size of circuit components. As cell geometry decreases, processing yields also decrease. This is especially true for a cell geometry smaller than 0.25 µm. Typical problems on array fabrication include structure design, photo alignment margin, thin film deposition conformality, etching aspect ratio, defect density, and process generated particles.

### SUMMARY OF THE INVENTION

Accordingly, a need has arisen for a robust and reliable memory cell structure that address the above-mentioned issues and gives a high processing yield. According to the teachings of the present application, such a method and structure are provided that address the disadvantages and problems associated with previous methods and structures.

In accordance with the present teachings, a plugged crown memory cell may comprise: storage node plug (crown cell plug) and subsequently formed polysilicon cylinder or similar three dimensional structure.

In another disclosed embodiment, a method for manufacturing a plugged crown memory cell may comprise the following steps: (1) formation of storage node contact (memory cell plug); (2) formation of memory cell sidewall; and (3) etch back of crown poly and removal of core oxide (PSG) to form isolated and electrically separate memory cell.

The present application discloses plugged crown memory cells with a simple geometry, that have good mechanical stability. The disclosed design is also tolerant of significant lithographic misalignments.

Other technical advantages will be readily apparent to one skilled in the art from the following figures, descriptions, and claims.

### BRIEF DESCRIPTION OF THE DRAWINGS

For a more complete understanding of the present invention, and some of the advantages thereof, reference is now made to the following descriptions taken in connection with the accompanying drawings in which:
FIGURE 1 is a cross-sectional view showing one embodiment of a plugged crown memory cell; and
FIGURE 2 is a flow chart which depicts a method for forming a plugged crown memory cell.

### DETAILED DESCRIPTION OF THE INVENTION

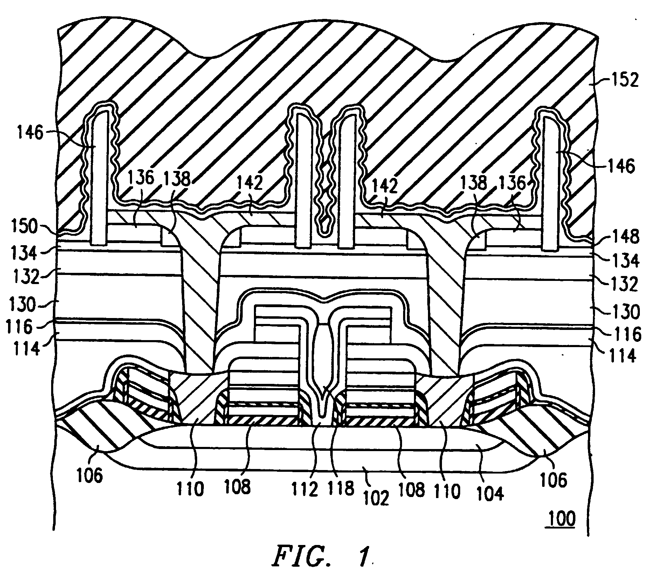

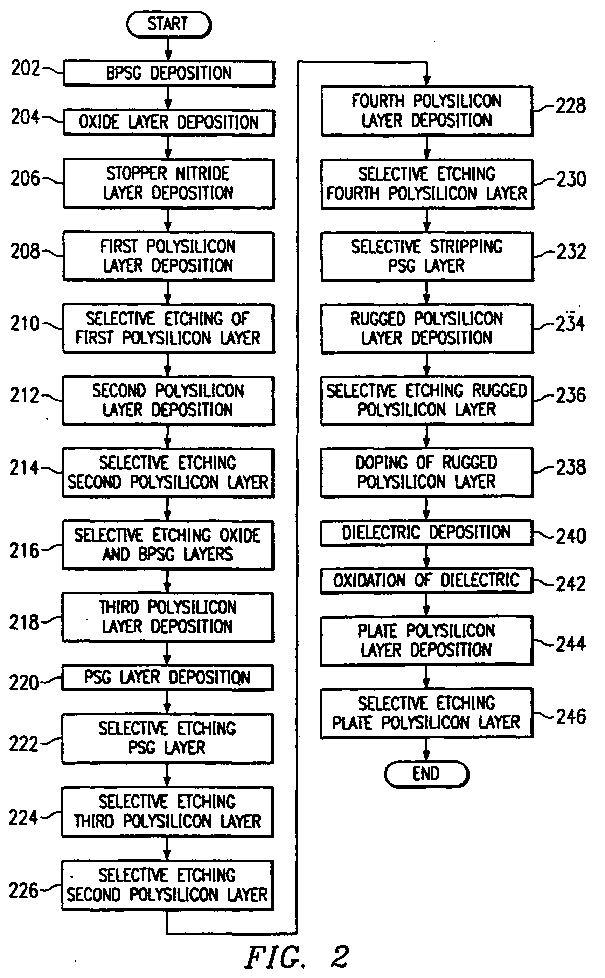

The illustrative embodiments of the present application and their advantages are best understood by referring to FIGURES 1 and 2 of the drawings, like numerals being used for like and corresponding parts of the various drawings.

FIGURE 1 is a cross-sectional view of one embodiment of a plugged crown memory cell. Plugged crown memory cell 100 includes deep N-well 102, which may consist of B⁺ implant, and array P-well 104, which may be implanted doped phosphorus formed on top of deep N-well 102. Local Oxidation of Silicon (LOCOS) isolation region 106 may be formed by first growing a pad-oxide layer (SiO₂) (not shown) on the surface of array p-well 104 by exposing array p-well 104 to oxygen in a controlled environment. A silicon nitride (Si₃N₄) layer (not shown) may then be deposited over the pad-oxide layer. Using known methods, these layers are then patterned with resist to define the width of a shallow isolation region 106 by etching away the nitride layer.

The regions covered by nitride are active regions, and those areas not covered by the nitride will become isolation regions. Once the Si₃N₄ has been patterned and etched, the substrate may be subjected to a second oxidation process whereby SiO₂ is grown substantially only in the isolation regions. Variations of this basic LOCOS process may also be used to create modified isolation structures.

Plugged crown memory cell 100 further comprises first gate (FG) stack 108 (comprising WSi₂/poly-silicon stack); poly-silicon plug 110; BL with WSi₂/poly-silicon stack 112; boronphosphosilicate glass (BPSG) layer 114; and thin nitride layer 116. Thin nitride layer 116 may be Si₂N₄, and is deposited thermally in a range of 10-50 nm to protect first BPSG layer 114 from stripping during the crown oxide phosphorus silicate glass (PSG) wet etch. BPSG is used to fill in the memory cell and to assist in the planarization process. Bitline contact (BLCT) 118 is the bitline contacting the moat directly.

FIGURE 2 is a flowchart illustrating the process to achieve a plugged crown memory cell. Referring now to both FIGURES 1 and 2, in step 202, second BPSG layer 130 is deposited by chemical vapor deposition using TEOS/0₃ precursor and dopant gases, PH₃/B₂H₆.

In step 204, high temperature and low pressure deposition (HLD) is used to form an oxide layer 132. For example, a layer of SiO₂ may be formed using tetraethoxysilane ("TEOS") precursor. Oxide layer 132 may occur after another BPSG deposition and reflow to planarize the memory cell. Oxide layer 132 may utilize any known deposition technique that produces a conformal and non-doped SiO₂ layer. Oxide layer is formed, in part, to protect first BPSG layer 114 from moisture attacks. This deposition may be performed at a temperature in the range from about 600°C to about 750°C. In one embodiment, it may be performed at 680°C. Oxide layer 132 may have a thickness in the range from about 100 Å to 1000 Å. In one embodiment, it has a thickness of 500 Å.

In step 206, a stopper nitride layer 134 may be deposited. Stopper nitride layer 134 functions to protect the underlying layers from being etched away by wet etching. Stopper nitride layer 134 may be Si₃N₄, or it may be any plasma nitride. Stopper nitride 134 may be deposited on top of oxide layer 132 with a chemical vapor deposition process. This may be a conformal deposition, such as high temperature, low pressure chemical vapor deposition (LPCVD), typically conducted in a furnace. This deposition may be performed at a temperature in the range of about 650°C to about 800°C. In one embodiment, it may be performed at 780°C. Stopper nitride layer 134 may have a thickness from about 200 Å to about 1000 Å, depending on poly-silicon/nitride etch selectivity and stress condition. In one embodiment, stopper nitride layer 134 has a thickness of about 700 Å.

In step 208, a first poly-silicon layer 136 may be deposited above stopper nitride layer 134. This may be accomplished by LPCVD furnace polysilicon deposition, discussed above. This deposition may be performed at a temperature in the range of about 540°C to about 700°C. In one embodiment, it may be performed at 540°C in order to have amorphous silicon deposition to fill the storage node contact (SNCT). First poly-silicon layer 136 may have a thickness from about 1000 Å to about 1500 Å. In one embodiment, first poly-silicon layer 136 has a thickness of about 1200 Å.

First poly-silicon layer 136 may be doped with n-type impurities having a concentration in the range from about 1.0 x 10²⁰/cm⁻³ to about 4.5 x 10²⁰/cm⁻³. In one embodiment, a dopant concentration of about 1.5 x 10²⁰ may be used. Other suitable dopant concentrations may be used. In step 210, first poly-silicon layer 136 may be selectively etched as a SNCT hole. This may be accomplished by using photolithography and followed by poly-silicon etch. Any known photolithography technique may be used. In one embodiment, a SNCT pattern may be used. The photolithography is performed in order to open at least two gaps (not shown) by removing that portion of first poly-silicon layer 136 exposed in the patterned SNCT area. First poly-silicon layer 136 is used as a hard mask for the SNCT deep hole etch.

In step 212, a second poly-silicon layer 138 may be deposited on stopper nitride layer 134 and on first poly-silicon layer 136 and in the gaps formed by step 210. This may be performed by any known deposition technique. In one embodiment, LPCVD furnace poly-silicon may be used. This deposition may be performed at a temperature in the range from about 540°C to about 600°C. In one embodiment, it may be performed at about 580°C. Second poly-silicon 138 may have a thickness from about 800 Å to about 1200 Å. In one embodiment, it has a thickness of about 1000 Å.

Second poly-silicon layer 138 may also be doped with n-type impurities having a concentration in the range from about 1.0 x 10²⁰/cm⁻³ to about 4.5 x 10²⁰/cm⁻³. In one embodiment, a dopant concentration of about 1.5 x 10²⁰/cm⁻³ may be used. Other suitable dopant concentrations may be used.

In step 214, second poly-silicon layer 138 may be selectively etched, using any known etching technique. In one embodiment, electron cyclotron resonation (ECR) etcher may be used. Step 214 is performed to form a plurality of sidewall spacers out of the remaining second poly-silicon layer 138, which sidewall spacers are formed on the inside of first poly-silicon 136 near gaps (not shown) created in step 210.

In step 216, oxide layer 132 and second BPSG layer 130 are selectively etched back. Any known etching technique may be used. In one embodiment, SNCT dry etching may be used. This may be accomplished by using SiN₄, SiO₂, Si₃N₄, or SiO₂ dry etch. At the completion of this step, gaps have been formed in the upper surface of plugged crown memory cell 100 and extend to poly-silicon plugs 110.

In step 218, a third poly-silicon layer 142 may be deposited. This may be performed by any known deposition technique. In one embodiment, LPCVD furnace poly-silicon may be used. This deposition may be performed at a temperature in the range from about 540°C to about 700°C. In one embodiment, it may be performed at about 580°C. Third poly-silicon layer 142 may have a thickness from about 800 Å to about 1500 Å. In one embodiment, it has a thickness of about 1200 Å.

Third poly-silicon layer 142 may also be doped with n-type impurities having a concentration in the range from about 1.0 x 10²⁰/cm⁻³ to about 4.5 x 10²⁰/cm⁻³. In one embodiment, a dopant concentration of about 1.5 x 10²⁰/cm⁻³ may be used. Other suitable dopant concentrations may be used.

Third poly-silicon layer 142 fills the gaps that extend to poly-silicon plugs 110 and covers first and second poly-silicon layers 136 and 138.

In step 220, phosphorus silicate glass (PSG) layer (not shown), or p-doped glass, may be deposited on top of third poly-silicon layer 142. This may be performed by any known deposition technique. In one embodiment, LPCVD furnace TEOS/PH₃ may be used. This deposition may be performed at a temperature in the range from about 400°C to about 550°C. In one embodiment, it may be performed at about 480°C. PSG layer (not shown) may have a thickness from about 1000 Å to about 8000 Å. In one embodiment, it has a thickness of 5000 Å.

In step 222, PSG layer (not shown) may be selectively etched by an oxide etch. This may be accomplished by using photolithography. Any known photolithography technique may be used. In one embodiment, a storage node pattern may be used to define a storage node size. The photolithography is performed in order to define the width of the storage node, and create the separation distance between adjacent nodes.

In step 224, third poly-silicon layer 142 may be selectively etched. Any known etching technique may be used. In one embodiment, SN dry etching for the PSG may be used. At the completion of this step, PSG layer (not shown) defines a storage cell.

In step 226, second poly-silicon layer 138 may be selectively etched back to remove that portion of poly-silicon layer 142 that is exposed by selective etching PSG layer (not shown). Any known etching technique may be used. In one embodiment, poly-silicon dry etching may be used. At the completion of this step, storage node is separated, and hence the storage cell is separated without a storage node poly-silicon connection.

In step 228, a fourth poly-silicon layer 146 may be deposited. This may be performed by any known deposition technique. In one embodiment, LPCVD furnace poly-silicon may be used. This deposition may be performed at a temperature in the range from about 540ºC to about 700ºC. In one embodiment, it may be performed at about 580ºC. Fourth poly-silicon layer 146 may have a width from about 300 Å to about 1200 Å. In one embodiment, it has a width of 1000 Å.

Fourth poly-silicon layer 146 may also be doped with n-type impurities having a concentration in the range from about 1.0 x 10²⁰/cm⁻³ to about 4.5 x 10²⁰/cm⁻³. In one embodiment, a dopant concentration of about 4.5 x 10²⁰/cm⁻³ may be used. Other suitable dopant concentrations may be used.

In step 230, fourth poly-silicon layer 146 may be selectively etched back. This is performed to remove the poly-silicon on the peripheries and to isolate each memory cell (storage node). Any known etching technique may be used. In one embodiment, poly-silicon dry etching may be used. At the completion of this step, a plurality of storage nodes, each with a crown shape, are formed, each being separated from the other storage nodes.

In step 232, the remaining PSG layer (not shown) not previously etched is selectively stripped. This may be performed by any known stripping technique.

In step 234, rugged poly-silicon layer 148 deposition may be performed. A suitable rugged poly-silicon is available from Tokyo Electron Limited, Tokyo, Japan. The deposition of rugged poly-silicon layer 148 and option or addition to the structure of FIGURE 1. This deposition may be performed by any known deposition technique. In one embodiment, LPCVD furnace poly-silicon may be used. This deposition may be performed at a temperature in the range from about 565°C to about 580°C. In one embodiment, it may be performed at about 575°C. Rugged poly-silicon layer 148 may have a thickness from about 300 Å to about 1000 Å. In one embodiment, it has a thickness of about 500 Å.

In step 236, rugged poly-silicon layer 148 may be etched back. Any known etching technique may be used. In one embodiment, poly-silicon dry etching may be used. At the completion of this step, each crown cell is separated may have its surface area doubled due to the hemispherical surface of rugged poly-silicon layer 148.

In step 238, rugged poly-silicon layer 148 may be doped with n-type impurities. This doping may be performed by any known doping technique. In one embodiment, phosphorus doping by PH₃ gaseous phase doping may be used. This may be performed at a temperature in the range from about 700°C to about 850°C. In one embodiment, it may be performed at about 850°C, for about 5 minutes.

In step 240, dielectric 150 may be deposited on the device. Dielectric 150 may coat the surface area of the entire device. Suitable dielectrics include Si₃N₄ and oxide. In one embodiment, Si₃N₄ may be used as a dielectric and may be used to create the capacitor on the device. This may be performed by any known deposition technique. In one embodiment, LPCVD furnace nitride (or single wafer rapid thermal chemical vapor deposition) may be used. This deposition may be performed at a temperature in the range from about 650°C to about 800°C. In one embodiment, it may be performed at about 745°C. The dielectric may have a thickness from about 40 Å to about 70 Å. In one embodiment, it has a thickness of about 60 Å. Under some circumstances, it may be desirable to use layers of multiple dielectrics.

In step 242, dielectric 150 may optionally be oxidized. This may be accomplished by using furnace oxidation and rapid thermal oxidation in a single wafer reactor. This is performed in order improve the electronic storage capacity and decrease less cell leakage.

In step 244, plate poly-silicon layer 152 may be deposited. This may be performed by any known deposition technique. In one embodiment, LPCVD furnace poly-silicon (or a single-wafer poly-silicon deposition reactor) may be used. This deposition may be performed at a temperature in the range from about 540°C to about 700°C. In one embodiment, it may be performed at about 545°C. Plate poly-silicon layer 152 may have a thickness from about 1000 Å to about 2000 Å. In one embodiment, it has a thickness of about 1200 Å.

Plate poly-silicon layer 152 may also be doped with n-type impurities having a concentration in the range from about 1.0 x 10²⁰/cm⁻³ to about 4.5 x 10²⁰/cm⁻³. In one embodiment, a dopant concentration of 4.5 x 10²⁰/cm⁻³ may be used. Other suitable dopant concentrations may be used.

In step 246, plate poly-silicon layer 152 may be selectively etched. This may be accomplished by using photolithography. Any known photolithography technique may be used. In one embodiment, a plate pattern with a photoresist covering memory cell area, may be used. The photolithography is performed in order to apply plate voltage through metal and via contact to control device operation. Plate poly-silicon layer coats the device and remains on top of only the memory cell (while not on the periphery) after an additional plate pattern, and plate poly-silicon etch. Additional etching, such as poly-silicon dry etching, may also be performed. At the completion of this step, plate poly-silicon layer 150 remains only in the memory cell area.

The Plugged Crown Memory Cell of the present invention has the advantages of robust manufacturing, simple geometry with good mechanical stability, and low defect density and particle generation during memory cell fabrication. In particular, the plugged crown memory cell of the present invention uses a nitride stopper with a good adhesion base upon which the memory cell may sit. The nitride stopper can serve as a stripping stopper for core SN oxide (PSG. PBSG, or NSG) before dielectric deposition. With the stopper nitride on bottom of the storage cells, there are no incubation problems, which can typically occur at storage node poly-silicon and oxide junction surfaces having different nucleation rates of poly-silicon and oxide. Since longer incubation (time to start deposit dielectric nitride) is required for oxide than for poly-silicon, a thinner dielectric nitride on oxide than on poly-silicon will experience high storage cell leakage at the junctions between oxide and poly-silicon. By using a stopper nitride and pinch-off SNCT, SN poly-silicon filled SNCT, the whole storage cells are stably plugged in a whole structure and a crown lifting problem from using a torch crown cell can be solved. Thus, even if there is a misalignment between SNCT and plug, the possibility of crown lifting is still reduced.

In addition, step coverage (thin film conformality) of dielectrics and plate poly-silicon is improved compared to that of a more conventional partially-completed DRAM cell.

The process flow of FIGURE 2 should not be solely limited by the list. In addition, additional process can be added on top of the fabricated plugged storage crown node before cell dielectric deposition. One such additional example is rugged poly-silicon deposition following rugged poly-silicon etch back, or hemispherical grain (HSG) deposition, which may be selectively grown on amorphous silicon and transforms the amorphous silicon into poly-silicon crystals having a hemispherical shape similar to that of rugged poly-silicon.

While the invention has been particularly shown and described by the foregoing detailed description, it will be understood by those skilled in the art that various other changes in form and detail may be made without departing from the spirit and scope of the invention.

## Claims

1. A method of fabricating a plugged crown memory cell comprising:
forming a BPSG layer on a partially-completed dynamic random access memory cell;
forming an oxide layer on said BPSG layer;
forming a stopper nitride layer on said oxide layer;
forming a first poly-silicon layer on said stopper nitride layer;
forming a second poly-silicon layer on said first poly-silicon layer;
selectively removing portions of said oxide layer and said BPSG layer;
forming a third poly-silicon layer on said second poly-silicon layer;
forming a fourth poly-silicon layer; and
isolating at least one memory cell.

2. The method of claim 1, wherein said step of forming a first poly-silicon layer on said stopper nitride layer comprises:
depositing said first poly-silicon layer on said stopper nitride layer; and
selectively removing portions of said first poly-silicon layer to form at least one gap.

3. The method of claim 1 or claim 2, wherein said step of forming a second poly-silicon layer on said first poly-silicon layer comprises:
depositing said second poly-silicon layer on said first poly-silicon layer; and
selectively removing portions of said second poly-silicon layer to form a plurality of sidewall spacers adjacent said first poly-silicon layer.

4. The method of any of claims 1 to 3, wherein said step of forming a third poly-silicon layer on said second poly-silicon layer comprises:
depositing said third poly-silicon layer on said second poly-silicon layer and filling a plurality of gaps;
selectively removing portions of said third poly-silicon layer; and
selectively removing portions of said second poly-silicon layer.

5. The method of any of claims 1 to 4, wherein said step of forming a fourth poly-silicon layer comprises:
depositing said fourth poly-silicon layer; and
selectively removing portions of said fourth poly-silicon layer.

6. The method of any of claims 1 to 5, wherein said step of forming said stopper nitride layer comprises depositing said stopper nitride layer by high temperature low pressure chemical vapor deposition.

7. The method of any of claims 1 to 6, wherein said step of forming said stopper nitride layer comprises forming said stopper nitride layer from a material selected from a group consisting of Si₃N₄ and plasma nitrides.

8. The method of any of claims 1 to 7, wherein said step of forming said second poly-silicon layer comprises depositing a second polysilicon layer and a third polysilicon layer that and said third poly-silicon layer are doped with n-type impurities.

9. The method of any of claims 1 to 8, further comprising:
forming a rugged poly-silicon layer; and
removing portions of said rugged poly-silicon layer.

10. The method of claim 9, further comprising:
forming a dielectric layer over the partially formed plugged crown memory cell;
forming a layer of plate poly-silicon over said dielectric layer; and
removing portions of said layer of plate poly-silicon.

11. A structure for forming a plugged crown memory cell comprising:
a partial dynamic random access memory cell that includes a gate region, an insulator layer disposed over a source region and a drain region, and a storage node contact region in the insulator layer disposed over a portion of the drain region;
a stopper nitride layer disposed over said insulator layer; and
a plurality of crown memory cells formed over the stopper nitride layer and extending through said layer to the storage node contact area.

12. The structure of claim 11, wherein said plurality of crown memory cells comprise:
a first poly-silicon layer disposed over said stopper nitride layer;
a second poly-silicon layer disposed adjacent said first poly-silicon layer and having a plurality of gaps formed therein; and
a third poly-silicon layer disposed on said second poly-silicon layer and said first poly-silicon layer, and filling the plurality of gaps.

13. The structure of claim 12, wherein said plurality of crown memory cells further comprise:
a PSG layer disposed on said third poly-silicon layer; and
a fourth poly-silicon layer disposed on said third poly-silicon layer.

14. The structure of claim 13, wherein said plurality of crown memory cells further comprise:
a rugged poly-silicon layer;
a dielectric layer formed over said rugged poly-silicon layer; and
a layer of plate poly-silicon formed on said dielectric layer.

15. A plugged crown memory cell comprising:
a partial dynamic random access memory cell that includes a gate region, an insulator layer disposed over a source region and a drain region, and a storage node contact region in the insulator layer disposed over a portion of the drain region;
a BPSG layer formed on said partially-completed dynamic random access memory cell;
an oxide layer formed on said BPSG layer;
a stopper nitride layer formed on said oxide layer;
a first poly-silicon layer formed on said stopper nitride layer;
a second poly-silicon layer formed on said first poly-silicon layer;
a third poly-silicon layer formed on said second poly-silicon layer; and
a fourth poly-silicon layer formed on said third poly-silicon layer.

16. The plugged crown memory cell of claim 15, wherein said stopper nitride is selected from a group of materials consisting of Si₃N₄ and plasma nitrides.

17. The plugged crown memory cell of claim 14 or claim 15, further comprising:
a rugged poly-silicon layer;
a dielectric layer formed on said rugged poly-silicon layer; and
a layer of plate poly-silicon formed on said dielectric layer.

18. The plugged crown memory cell of any of claims 14 to 17, wherein said second poly-silicon layer and said third poly-silicon layer are doped with n-type impurities.

19. The plugged crown memory cell of claim 17 or claim 18, wherein said rugged poly-silicon layer has a substantially hemispherical surface.
